Europäisches Patentamt

European Patent Office

Office européen des brevets

(11) Publication number: **0 297 508**
**A2**

# (12) EUROPEAN PATENT APPLICATION

(21) Application number: 88110298.2

(22) Date of filing: 28.06.88

(51) Int. Cl.⁴: **H01L 27/08 , H01L 29/205**

(30) Priority: 02.07.87 US 69474

(43) Date of publication of application:
04.01.89 Bulletin 89/01

(84) Designated Contracting States:
DE FR GB IT

(71) Applicant: **International Business Machines Corporation**
**Old Orchard Road**
**Armonk, N.Y. 10504(US)**

(72) Inventor: **Kiehl, Richard Arthur**
**76 Constitution Way**
**Convent Station New Jersey 07961(US)**

(74) Representative: **Hobbs, Francis John**
**IBM United Kingdom Limited Intellectual Property Department Hursley Park**
**Winchester Hampshire SO21 2JN(GB)**

(54) Complementary heterostructure semiconductor device.

(57) Semiconductor heterostructure technology is provided wherein parallel quantum well interfaces (2, 4, 6, 8, 10) serially removed from a surface (12) having one device area adjacent one quantum well interface and another device area vertically displaced and adjacent another quantum well interface providing a direct connected complementary switching device integrated circuit. An eight layer (1, 3, 5, 7, 9, 11, 13, 14) alternating GaAlAs/GaAs substrate (1) is provided with a vertical differentiation of the device areas on the surface such that alternate wide (3, 7, 11) and narrow (5, 9) band gap layers are adjacent different areas for the fabrication of complementary quantum well channel field effect transistors wherein the quantum well interface for one conductivity type channel device extends under the quantum well interface for the opposite conductivity type channel device and does not interfere with it.

FIG. 13

# COMPLEMENTARY HETEROSTRUCTURE SEMICONDUCTOR DEVICE

## Technical Field

The technical field of the invention is in complementary integrated circuits wherein both p and n type transistors are interconnected in the same circuit entity.

In the complementary type of integrated circuit, the realization of higher speeds and more precise performance requires faster carrier transport, more precision in turning on and off and less gate and drain leakage.

In a particularly advantageous type of such structure, the channel regions of the p and n type field effect transistors are in regions between interfaces of different semiconductor materials known as quantum wells. Under these conditions, the carriers, either electrons or holes, are confined in the wells in the form of a two-dimensional gas.

## Background Art

Heretofore in the art, complementary structures had been fabricated by integrating GaAs metal-semiconductor (MESFET) type field effect transistors and by three types of heterostructure field effect transistors. In the metal-insulator semiconductor (MISFET) type field effect transistor there is a metal gate and a high resistivity or intrinsic AlGaAs region interfacing with a high resistivity or intrinsic GaAs region so that the FET channel is in the GaAs region adjacent to the interface. In the semiconductor insulator semiconductor (SISFET) type field effect transistor there is a doped semiconductor gate forming an interface with a high resistivity or intrinsic wider band gap semiconductor insulating region, which in turn forms a second interface with a high resistivity or intrinsic narrower band gap semiconductor region so that the FET channel is in the region of narrower band gap semiconductor adjacent the second interface. In the modulation doped (MODFET) type field effect transistor, there is a metal gate on a doped, wider band gap semiconductor region which forms an interface with a high resistivity or intrinsic narrower band gap semiconductor region so that the FET channel is in the narrow band gap semiconductor region adjacent the interface with the wider band gap semiconductor.

All of the MESFET, MISFET, SISFET and MODFET type structures have less than desirable performance resulting from an inability to obtain proper field effect transistor threshold levels and low gate leakage currents.

In the matter of leakage, the MESFET and MODFET type structures appear to suffer the most from gate leakage, whereas the MISFET and SISFET type structures appear to have favorable low gate leakage at low temperatures. As the temperature reaches room temperature, however, the leakage level in these types of structures also becomes intolerable.

In the matter of threshold, the signal required to turn the FET "on", the signal is too high for high speed at low power levels in the MISFET type structure and in the SISFET structure, it is too low for achieving a margin over normal circuit noise and for achieving low drain leakage current.

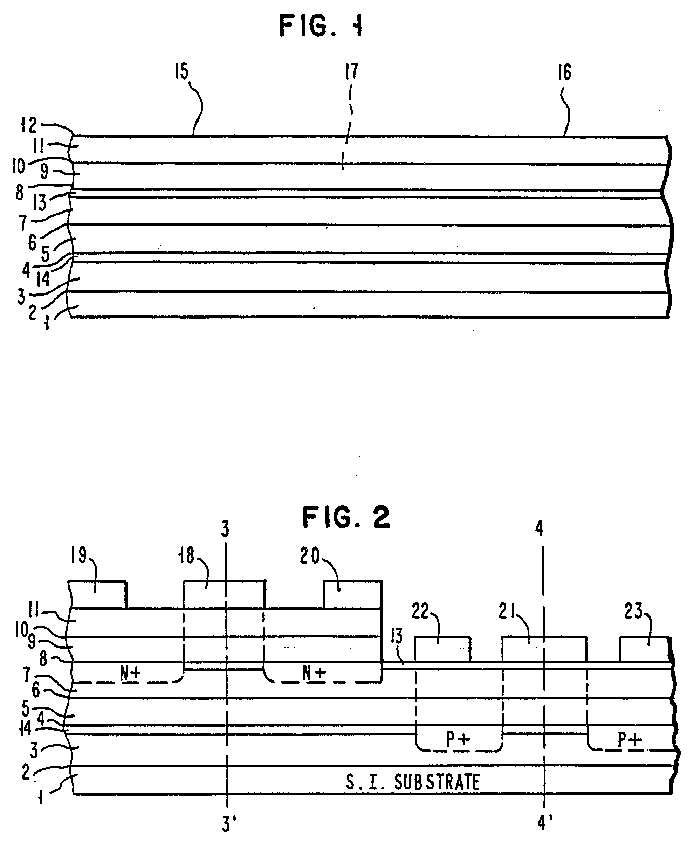

One example of the present state of the art in side by side MISFET type complementary integrated circuit structures is shown in Figure 1 of an article entitled Complementary Heterostructure Insulated Gate Field Effect Transistors (HIGFETs) by N.C. Cirillo, Jr., et al, IEEE IEDM Technical Digest, 1985.

Another example of the present state of the art in complementary direct coupled MESFET circuits in GaAs is shown in IEEE Electron Device Letters Vol. ED-8, No. 6, June 1987, pages 260-262, wherein the above-described leakage, threshold and signal level problems are apparent.

An improvement in threshold control and leakage current in individual devices is shown in Japanese Journal of Applied Physics, Vol. 23, page L836, Nov. 1984, in an article entitled "A New Insulated-Gate Inverted-Structure Modulation-Doped AlGaAs/GaAs/N-AlGaAs Field-Effect Transistor" by Kinoshita et al wherein a thin doped layer near the bottom edge of the quantum well operates to provide controllable threshold voltages and significantly lower gate leakage levels. Such a structure however has disadvantages in that the quantum well channel must be conducting to permit contact to be made to electrons induced under the gate which in turn interferes with the ability to bury the structure in a single growth, layered integration. Further, high access resistance is encountered since the quantum well in the regions outside of the gate is only partially accumulated with electrons.

## Brief Description of the Drawings

FIG. 1 is a cross-sectional view of a multilayered substrate structure employed in the invention.

FIG. 2 is a cross-sectional view of the complementary structure of the invention.

FIG. 3 is an energy diagram taken along the line 3-3' of FIG. 2.

FIG. 4 is an energy diagram of the portion of the structure of FIG. 2 along the line 4-4'.

FIG. 5 is a composite energy diagram of the diagrams of FIGS. 3 and 4.

FIGS. 6-13 are structural illustrations of various partially manufactured products in construction of the complementary structure of FIG. 2.

## Disclosure of the Invention

The invention is a heterostructure wherein superimposed parallel quantum well interfaces are positioned with respect to a surface so that through planar operations a directly connected complementary n and p transistor integrated circuit may be fabricated.

In the structure of the invention, leakage and threshold of the switching devices are controlled by band offset between layers of material and doping.

In order to facilitate explanation, specific conductivity type n or p assignments and specific semiconductor material selections will be employed, although it will be apparent to one skilled in the art that in the light of the principles set forth many variations will be apparent.

In the invention, one conductivity type channel FET of the circuit is realized by gating the flow of one type of carrier in a potential well more proximate to the surface whereas the other conductivity type channel FET is realized by removing layers of the substrate structure in selected areas from the surface down to the proximity of the potential well that is farther removed from the surface and then providing a gating capability for the opposite type of carrier in that potential well.

Referring to FIG. 1, a cross-sectional view is shown of an intermediate multilayer substrate manufacturing product.

In FIG. 1, on a substrate 1, such as a semi-insulating compound semiconductor material having the properties of being able to support the structure and at the same time electrically isolate individual portions, there is provided, in an epitaxial structure, on the interface 2 of the substrate 1, two combinations of wide band gap, narrower band gap alternating layers of semiconductor material. In FIG. 1, a wide band gap layer 3 extends from the interface 2 to an interface 4, a narrower band gap layer 5 extends from the interface 4 to an interface 6, a wider band gap layer extends from the interface 6 to an interface 8, and a narrower band gap layer extends from the interface 8 to the interface 10 and a wider band gap 11 extends from the interface 10 to the surface 12.

Adjacent the interfaces 8 and 4 are threshold tailoring accommodation means 13 and 14, respectively. These means operate to bend the energy bands adjacent the potential well channel and are usually localized doping.

The area of the surface 12 is of sufficient size to at least permit separation into a region 15 in which a device of one conductivity type can be ed using the potential well adjacent interface 8 as the channel and a different region 16 in which a device of a second conductivity type using the potential well adjacent the interface 4 as the channel can be fabricated by a vertical differentiation operation performed along the line shown dotted as 17, that operates to remove the material down to a level where ohmic and gating functions for an FET transistor can be provided to the potential well more remote from the surface. In FIG. 1, this involves removal of regions 9 and 11 and exposes the surface of interface 8 in the region defined by 16.

FIG. 2 illustrates in cross section the complementary device structure that is fabricated from the structure of FIG. 1.

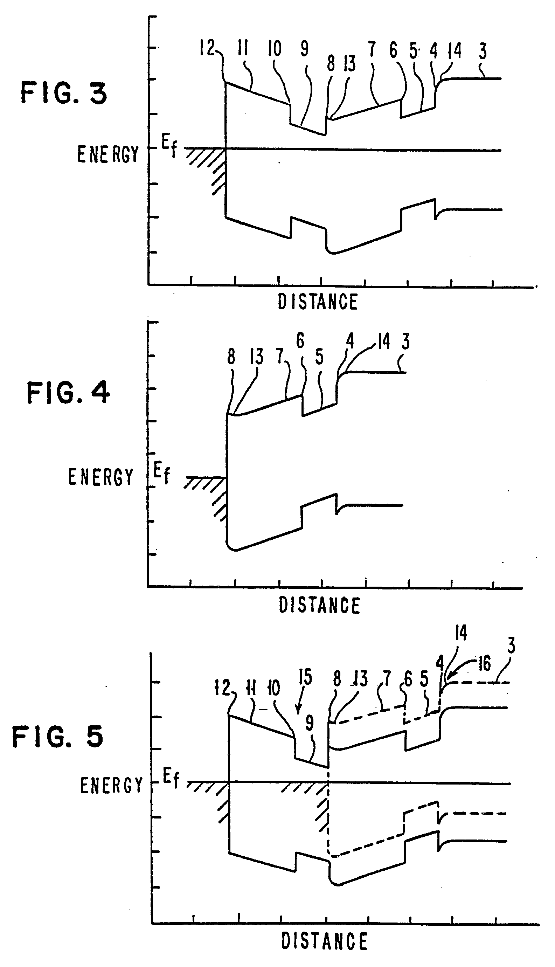

Referring next to FIGS. 3, 4 and 5, band energy diagrams of the substrate intermediate manufacturing product of FIG. 1 and the structure of FIG. 2 are shown. In FIG. 3, the band energy in the structure of FIG. 1 is illustrated using reference numerals for energy direction points taken along the lines 3-3' of FIG. 2. In FIG. 3, from the surface 12, layer 11 has a wide energy band gap, the layer 9 has a narrower energy band gap, the layer 7 has a wider energy band gap, the layer 5 has a narrower energy band gap, and the layer 3 adjacent the substrate has a wider energy band gap.

In FIG. 4, a similar energy band diagram is shown for the portion of the substrate of FIG. 1 along the line 4-4' after removal of the material in region 16.

In FIG. 5, a composite of FIGS. 3 and 4 is provided showing the energy levels in the regions 15 and 16 of FIG. 1 and illustrating the relative locations of the n and p channels and differences in potential energy in the two regions which arise from Fermi level pinning at the metal semiconductor interfaces.

The structure has several interdependent features that in combination operate to facilitate fabrication and provide performance advantages. The combination of the alternating wider and narrower band energy gap layers parallel to the surface permits opposite type carrier conduction, n and p quantum well channel switching devices superimposed parallel to the surface 12.

Means 13 and 14 are provided in FIG. 1 adjacent the potential well interfaces 8 and 4, respectively, to tailor the threshold. This may also be achieved by such means as localized crystal strain and the use of different semiconductor materials. The use of different semiconductor materials serves to tailor the threshold through differences in band gaps as well as in the conduction band offset at semiconductor to semiconductor and semiconductor to metal interfaces. Adjustment of layer thicknesses also may be used to adjust thresholds. In particular, the threshold may be tailored by quantization of the electron and hole energy levels in structures having on the order of 100Å or less narrow gap layers.

In FIGS. 3, 4 and 5, the threshold of the switching devices that will have their channels in the potential well at interface 8 for the n type and interface 4 for the p type is controlled as an illustrative example by the thin doped region, as element 13, adjacent the interface 8 and thin doped region, as element 14, adjacent the interface 4. The purpose of the thin doped regions is to bend the bands such that a precise selected separation from the Fermi level is established at interfaces 8 and 4. This separation from the Fermi level can be selected to produce the required thresholds for the n and p channel devices and negligible conductivity in layers 3, 5 and 7 in region 15.

It will be apparent to one skilled in the art that in the construction of the device of the invention first the band positions are established by the materials and then finer position selection can be achieved by localized crystal strain and doping.

While many variations in the light of the principles set forth will occur to one skilled in the art, the following are illustrative.

There are advantages to providing a different semiconductor material for each layer and for the means 13 and 14. When this is done, on one hand, to address gate leakage problems, the widest possible band gap would be desirable in layers 11 and 7, such as would be achieved using AlGaAs with a high Al,As mole fraction.

On the other hand, for threshold and carrier confinement purposes, the band gap in layers 5 and 9 would be tailored by decreasing an AlGaAs mole fraction of Al,As toward a narrower band gap material such as GaAs, or by using a low band gap material such as (In,Ga)As. Since doped layers do occasionally introduce trapping effects, the use of different materials such as low Al,As mole fraction AlGaAs, are advantageous for layers 13 and 14.

In FIG. 2, the same reference numerals as in FIGS. 1 and 3-5 are employed. The epitaxial structure of FIG. 2 in the region 15 over to the line of demarcation 17 of FIG. 1 is provided with a gate contact 18, which serves as a mask in introducing n type dopants preferably by the technique of ion implantation down through the layers 11 and 9 and into the layer 7, forming the n+ source and drain regions. The n+ regions are shown dotted adjacent to the gate 18. Source 19 and drain 20 ohmic contacts then complete a self-aligned n-channel field effect transistor device.

At the line of demarcation 17, an etch has been employed which removes the layers 11 and 9 down to the interface 8 of the layer 7 thereby removing the portion of the substrate of FIG. 1 in the area 16. On the exposed face of the layer 7 a gate 21 is positioned which also serves as a mask for an ion implantation operation in introducing p conductivity type impurities down through layers 7 and 5 and into the layer 3, providing the high conductivity p+ source and drain regions. The p+ regions are shown dotted adjacent to the gate 21. Ohmic source 22 and drain 23 contacts are then applied to the surface 7 providing a self-aligned p channel field effect transistor device.

As may be seen from FIG. 2 with the alternate wider and narrower band gap parallel layers, a simple vertical differentiation removing the material in area 16 along line 17 of FIG. 1 to layer 7 permits a p carrier type device to be positioned adjacent to an n carrier type device while having the p layers be under but unaffecting the n.

### Best Mode for Carrying Out the Invention

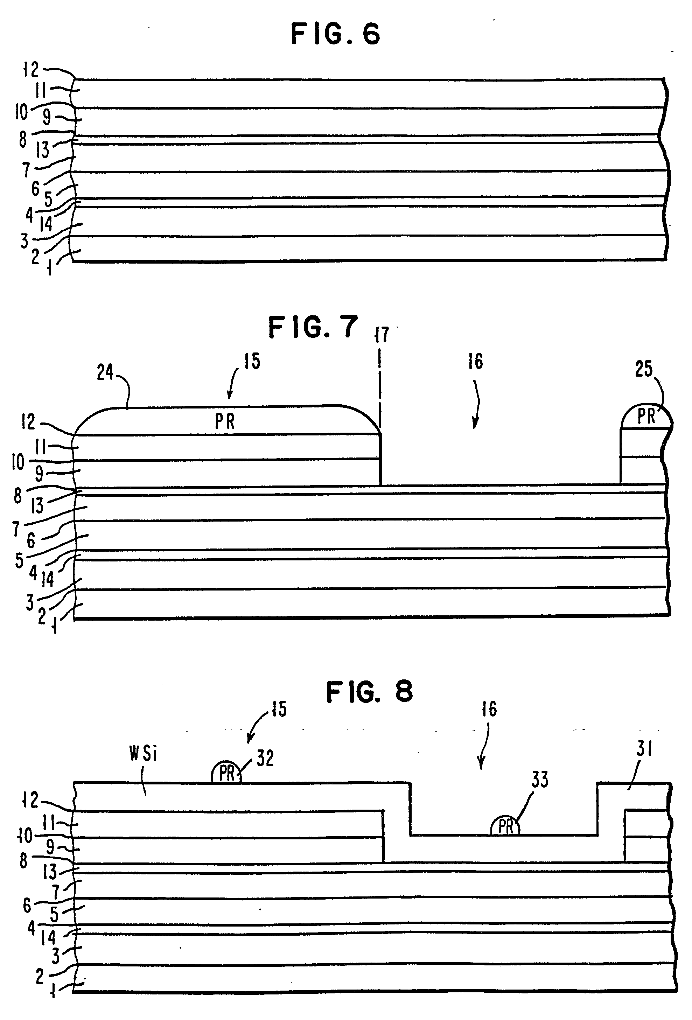

Referring to FIGS. 6 - 13, intermediate structures employing the same reference numerals as in FIGS. 1-5 are provided that illustrate a preferred method of fabrication of the structure of FIG. 2 where layer 11 is insulating or high resistivity AlGaAs, layer 9 is high resistivity GaAs, layer 13 is n conductivity type AlGaAs, layer 7 is high resistivity AlGaAs, layer 5 is high resistivity GaAs, layer 14 is p conductivity type AlGaAs, layer 3 is high resistivity AlGaAs and layer 1 is high resistivity GaAs.

In FIG. 6, an intermediate manufacturing product structure is shown as having eight layers in which the band bending means 13 and 14 are shown as regions of Si doped material in 13 and beryllium doped material in 14 as independent layers. In practice these may be individual layers as illustrated of, for example, different materials or very thin doped regions in layers 3 and 7. Further, in the light of the principles set forth, it will be apparent to one skilled in the art that the band bending means may be achieved by variations, such as spacing the doping from the adjacent interface and by other physical effects such as localized strain.

Referring next to FIG. 7, a photoresist is placed over the surface 12 in regions 24 and 25 and the region 16 beyond the line of demarcation 17 is eroded to expose the vicinity of the surface of the layer 7, interface 8 being illustrated in the region 16. Where the material with the high band gap is AlGaAs and the narrower band gap is GaAs, HCL may be used to remove the top AlGaAs layer only. Then a selective reactive ion etch, employing Freon 12 may be employed to remove the GaAs and stop on the surface 8 of the doped region 13.

Referring next to FIG. 8, a layer 31 of tungsten silicide which will serve as a refractory gate metal is applied. The area 16 has now been vertically differentiated with respect to the surface to a level to reach contacting range of the quantum well at interface 8. Photoresist patterns 32 and 33 are then placed on the tungsten silicide to define the gates of the devices.

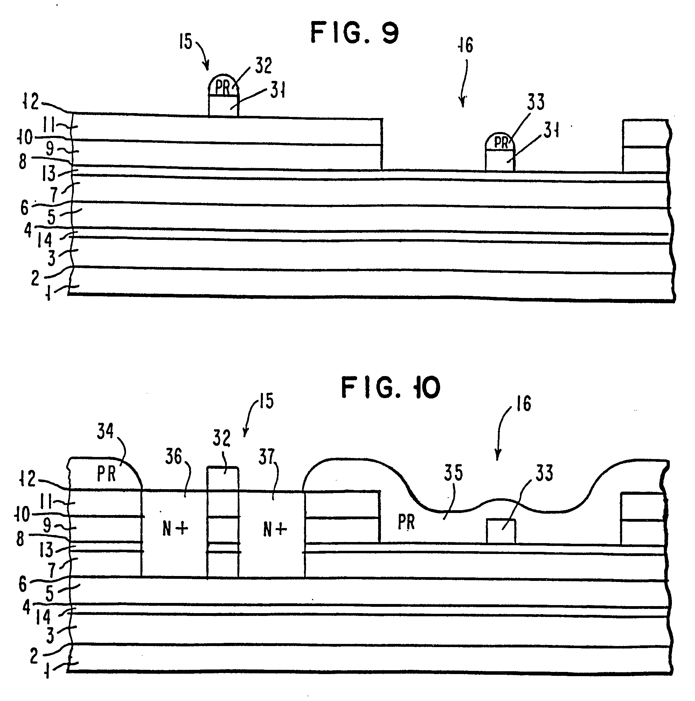

Referring to FIG. 9, the gates of the respective devices, labelled elements 32 and 33, are defined using a reactive ion etching operation in which the material photoresist over the tungsten silicide provide the definition of elements 32 and 33 as the gates.

Referring next to FIG. 10, a photoresist is placed over areas 34 and 35, so as to expose the source and drain regions of the transistor to be controlled by gate 32. An n+ silicon implant is then introduced into regions 36 and 37. The depth of the implants 36 and 37 are not critical so long as they reach interface 8.

Continuing to refer to FIG. 10, a similar operation would then take place in the area 16, wherein the photoresist 35 and 34 is removed, a photoresist protecting the area 15 would be applied leaving exposed the crystal surrounding the gate 33. Using the gate 33 as a mask, a p+ implant with an element such as magnesium is introduced to provide the source and drain regions of that transistor.

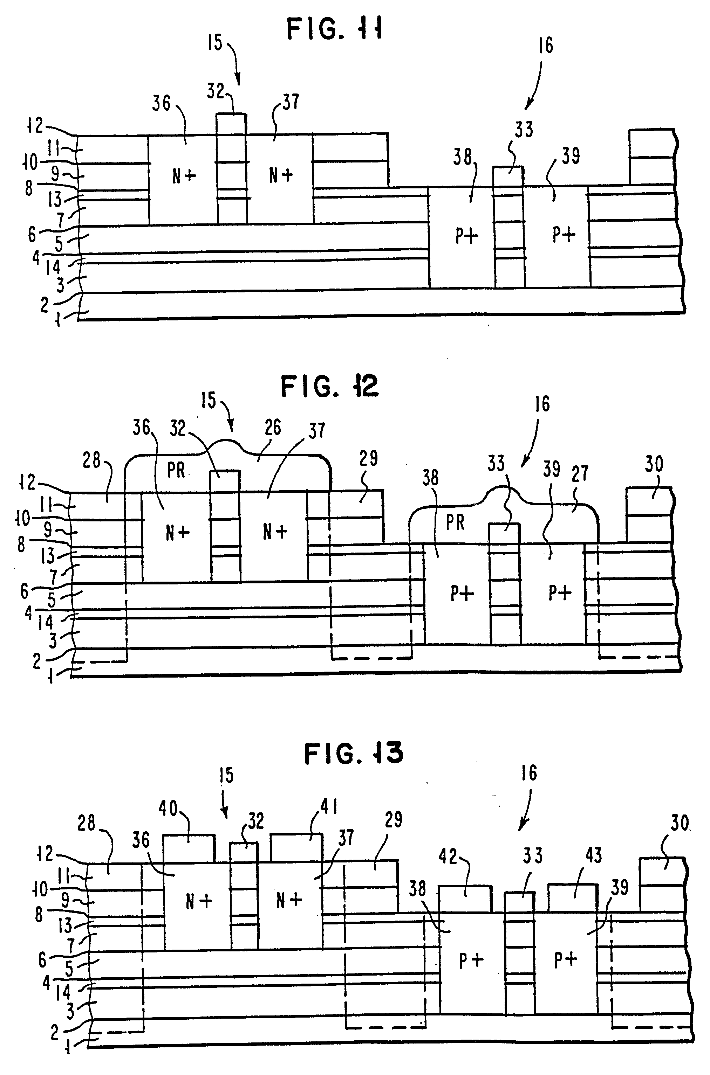

Referring next to FIG. 11, the implanted regions are shown specifically as 36 and 37 adjacent to gate 32, and 38 and 39 adjacent to gate 33. These implants are next annealed at about 850°C for about two seconds.

Referring next to FIG. 12, isolation between devices is next provided by applying a photoresist in regions 26 and 27 of areas 15 and 16, where the n and p type devices are being fabricated. In FIG. 12, isolation is shown provided in regions 28, 29 and 30, through an implantation in which an element such as oxygen is introduced. The oxygen implanted regions are shown in FIG. 12 with dotted lines.

Referring next to FIG. 13, the alloy metals serving as the ohmic contacts are next deposited, for the n-FET in area 15, gold germanium contacts 40 and 41 are applied with the rest of the device masked and then alloyed. Similarly in the area 16 for the p-FET, gold beryllium contacts 42 and 43 are deposited with the rest of the device masked and then alloyed.

What has been described is a semiconductor heterostructure device having superimposed n-channel and p-channel double quantum well layers so that with one vertical differentiation, complementary devices are achieved, the layers for one device extending under the other one while not interfering with its performance.

## Claims

1. An intermediate manufacturing product in the fabrication of complementary integrated circuit devices comprising:
a monocrystalline substrate (1) of epitaxial layers of semiconductor material providing therein first and second superimposed quantum well interfaces parallel to a surface (12), a portion of said surface (12) being removed through the quantum well interface proximate to said surface (12) and separate groups of field effect transistor ohmic contact (19, 20, 22, 23) and gate contact (18, 21, 32, 33) electrodes for each said circuit device, each group being positioned in current influencing proximity to each said quantum well interface (2, 4, 6, 8, 10).

2. The intermediate manufacturing product of Claim 1 wherein each said quantum well interface is the interface between a layer of higher (3, 7, 11) and a layer of lower band gap (5, 9) semiconductor material.

3. The intermediate manufacturing product of Claim 1 or 2 wherein said higher band gap material is AlGaAs and said lower band gap material is GaAs.

4. The intermediate manufacturing product of one of the Claims 1 - 3 wherein means are provided in said semiconductor material at each quantum well interface for device threshold selectivity.

5. The intermediate manufacturing product of one of the Claims 1 - 4 wherein said means is an extrinsic doped region in said layer with higher band (3, 7, 11) gap material at said quantum well interface.

6. The intermediate manufacturing product of one of the Claims 1 - 5 wherein an n conductivity doped layer is positioned in said first AlGaAs layer and a p conductivity doped layer is positioned in said second AlGaAs layer.

7. A complementary integrated circuit device comprising:
a monocrystalline member of epitaxial layers of semiconductor material providing therein first and second superimposed quantum well interfaces parallel to a surface (12), said first quantum well interface being proximate to said surface (12), and said second quantum well interface being remote from said surface (12), said second quantum well interface being proximate to an exposed area vertically differentiated from said surface (12),
a first group of ohmic contacts (19, 20) separated by a gate (18) in current influenc ing proximity to said first quantum well interface on said surface (12), and
a second group of field effect transistor ohmic contacts (22, 23) separated by a gate (21) in current influencing proximity to said second quantum well interface in said vertically differentiated area.

8. The circuit device of Claim 7 wherein each said quantum well interface is the interface between a layer of higher and a layer of lower band gap semiconductor material.

9. The circuit of Claim 7 and 8 wherein said higher band gap material is AlGaAs and said lower band gap material is GaAs.

10. The circuit of Claim 7, 8 and 9 including a region of extrinsic conductivity doped material in said higher band gap layer adjacent each said quantum well interface.

11. The circuit of Claims 7 - 10 wherein in said layer of higher band gap material at said quantum well interface there is a doped region of n conductivity type and in said higher band gap material layer adjacent said second quantum well interface there is a layer of p conductivity type doped material.

12. The process of fabricating complementary n and p conductivity type semiconductor devices comprising the steps of:
providing a substrate (1) of alternating higher band gap (3, 7, 11) and lower band gap (5, 9) semiconductor material in a monolithic epitaxial structure so as to provide superimposed first and second quantum well interfaces,
said first quantum well interface having a doped layer of n conductivity type in the high band gap region adjacent said interface and
said second quantum well interface having a doped layer of p conductivity type in the higher band gap layer adjacent said interface,
eroding a portion of said monolithic structure to within contacting proximity of said second superimposed quantum well interface,
providing a gate defining photoresist mask for each said n device and said p device in the center of the device area on a refractory metallic layer,
removing said metallic layer except under each said gate defining photoresist mask,
removing said gate defining photoresist from each of said n and p type device leaving said refractory metal thereunder as the gate of each device,
providing a photoresist mask over the entire surface with the active regions of the n transistor area exposed,
employing said refractory metal and said photoresist mask to define the area in the implantation of high conductivity n + regions in said n type device area,
repeating the steps of providing of a photoresist mask over the entire surface with the active regions of the p transistor area exposed and said implantation step to provide high conductivity p + regions in said p type device area,
separating regions by isolation implantation between them,
applying ohmic contacts (19, 20, 22, 23) to said high conductivity n + and p type implanted regions and said gate (18, 21) electrodes of said devices.

13. The process of Claim 12 wherein said higher band gap semiconductor material is AlGaAs and said lower band gap semiconductor material is GaAs.

14. The process of Claim 12 and 13 wherein said n conductivity doped region is doped with silicon and said p conductivity doped region is doped with beryllium.

88110298.2

## FIG. 1

## FIG. 2

EP 0 297 508 A2

88110298.2

**FIG. 3**

ENERGY

DISTANCE

**FIG. 4**

ENERGY

DISTANCE

**FIG. 5**

ENERGY

DISTANCE

## FIG. 6

## FIG. 7

## FIG. 8

88110298.2

## FIG. 9

## FIG. 10

88110298.2

# FIG. 11

15
32
36
37
16
33
38
39

12
11
10
9
8
13
7
6
5
4
14
3
2
1

N+    N+

P+    P+

# FIG. 12

15
36   32   26   37
16
33   39   27
28
29
38
30

12
11
10
9
8
13
7
6
5
4
14
3
2
1

PR

N+    N+

PR

P+    P+

# FIG. 13

15
40   32   41
16
33
28
36          37
29
42          43   30
38   39

12
11
10
9
8
13
7
6
5
4
14
3
2
1

N+    N+

P+    P+